(19) Europäisches Patentamt / European Patent Office / Office européen des brevets

(11) **EP 3 311 106 B1**

(12) **EUROPÄISCHE PATENTSCHRIFT**

(45) Veröffentlichungstag und Bekanntmachung des Hinweises auf die Patenterteilung:
**17.04.2019 Patentblatt 2019/16**

(21) Anmeldenummer: **16729517.9**

(22) Anmeldetag: **07.06.2016**

(51) Int Cl.:
*G01D 18/00* (2006.01)   *G01D 5/22* (2006.01)
*G01R 31/02* (2006.01)   *G01R 31/28* (2006.01)
*G01B 7/30* (2006.01)

(86) Internationale Anmeldenummer:
**PCT/EP2016/062846**

(87) Internationale Veröffentlichungsnummer:
**WO 2016/202630 (22.12.2016 Gazette 2016/51)**

(54) **VERFAHREN UND SCHALTUNG ZUM ERKENNEN EINES KURZSCHLUSSES DER SINUS- ODER KOSINUS-EMPFÄNGERSPULE EINES RESOLVERS**

METHOD AND CIRCUIT FOR DETECTING A SHORT CIRCUIT OF THE SINE OR COSINE RECEIVER COIL OF A RESOLVER

PROCÉDÉ ET CIRCUIT POUR DÉTECTER UN COURT-CIRCUIT DE LA BOBINE RÉCEPTRICE SINUS/COSINUS D'UN RÉSOLVEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.06.2015 DE 102015211216**

(43) Veröffentlichungstag der Anmeldung:
**25.04.2018 Patentblatt 2018/17**

(73) Patentinhaber: **Robert Bosch GmbH**
**70442 Stuttgart (DE)**

(72) Erfinder:
• **UNGERMANN, Michael**
  **64285 Darmstadt (DE)**
• **LECHNER, Benjamin**
  **75242 Neuhausen (DE)**
• **ZIRKEL, Daniel**
  **75446 Wiernsheim-Serres (DE)**
• **RAICHLE, Daniel**
  **71665 Vaihingen (DE)**

(56) Entgegenhaltungen:
EP-A1- 2 562 516     DE-A1-102008 022 979
US-A1- 2001 054 911     US-A1- 2012 185 213

EP 3 311 106 B1

**Beschreibung**

Die Erfindung betrifft ein Verfahren zum Erkennen eines Kurzschlusses einer Resolver-Signalleitung der Sinus- oder Kosinus-Empfängerspule nach Masse oder zur Betriebsspannung, und eine Schaltung zum Realisieren dieses Verfahrens.

Stand der Technik

Resolver dienen zum Ermitteln der Winkelstellung eines rotierenden Objekts, z.B. der Antriebswelle eines Motors. Im Stand der Technik gibt es verschiedene Resolvertypen. Grundsätzlich wird dabei mittels mindestens einer Spule ein sich änderndes magnetisches Feld erzeugt, und mittels mindestens einer weiteren Spule wird dieses Feld detektiert, wobei die Stärke der Kopplung zwischen den Spulen in Abhängigkeit von der zu messenden Position oder Winkelstellung variiert. Beim "Variable Reluctance Resolver" (VR-Resolver) beispielsweise kommt nur eine Erregerspule zum Einsatz und es gibt zwei Messspulen, die positionsabhängige Signale erzeugen. Die deutsche Patentanmeldung DE 10 2011 078 583 A1 offenbart beispielsweise eine Auswertung von Resolver-Sensorsignalen in einem Fahrzeug. Ein Resolver nimmt hierzu eine Drehbewegung eines Rotors auf, und ein Prozessorelement verarbeitet die sinus- bzw. kosinusförmigen Ausgangssignale des Resolver.

Die EP2562516 offenbart einen Rotationssensor und Rotationswinkelerfassungsvorrichtung für einen Lenkwinkel eines Fahrzeugs.

Die Erfindung geht von einem solchen Resolver aus, wobei das Erregersignal sinusförmig ist und typischerweise eine Frequenz von 10 kHz hat. Die beiden Messspulen sind in der Regel orthogonal zueinander positioniert und werden als Sinus- und Kosinusspule bezeichnet. Mit den beiden Messsignalen ist der Winkel des Messobjekts eindeutig bestimmbar.

Das Erregersignal für die Erregerspule kann beispielsweise durch zwei Gegentaktendstufen bereitgestellt werden, je eine für die beiden Anschlüsse der Erregerspule. Die Ausgangssignale der beiden Endstufen sind dann um 180° zueinander phasenverschoben und das für die Erregerspule wirksame Erregersignal ist die Differenzspannung zwischen den Ausgängen der beiden Endstufen.

Es besteht aber auch die Möglichkeit, die Erregerspule durch nur eine Endstufe zu betreiben. Der zweite Anschluss der Erregerspule ist dann entweder direkt oder über einen Kondensator auf ein festes Potential, z. B. Massepotential gelegt.

An den Empfängerspulen entsteht ein Wechselspannungssignal mit derselben Frequenz wie das Erregersignal, dessen Amplitude jedoch entsprechend der Rotorlage moduliert ist, wobei das Signal an der Kosinusspule um 90° gegenüber dem Signal an der Sinusspule phasenverschoben ist.

Resolver werden häufig zur Regelung von permanenterregten Synchronmaschinen (PSM) und elektrisch erregten Synchronmaschinen (ESM) eingesetzt, die z.B. als Antrieb für Hybrid- und Elektrofahrzeuge Verwendung finden. Für eine solche Regelung ist die Kenntnis der aktuellen Rotorwinkellage notwendig. Bei der Regelung von Asynchronmaschinen (ASM) ist die Kenntnis der aktuellen Frequenz des Antriebs erforderlich.

Wegen ihrer Robustheit werden in Kraftfahrzeugen für diese Zwecke bevorzugt Resolver eingesetzt, auch wenn es alternative Sensoren gibt, z.B. digitale Winkelgeber oder Sensoren auf der Basis des Wirbelstromeffekts.

Für Sensoren im Automobilbereich sind Diagnosemöglichkeiten möglicher Fehler wünschenswert. Bei Resolvern, wie sie die vorliegende Anmeldung zum Gegenstand hat, ist ein möglicher, zu diagnostizierender Fehler ein Kurzschluss einer Resolver-Signalleitung nach Masse oder zur Betriebsspannung $U_B$. Dabei wird im Folgenden unter einem Kurzschluss nur eine ungewollte elektrische Verbindung einer der Signalleitungen mit Masse oder mit der Betriebsspannung $U_B$ verstanden, wobei die Diagnose auch feststellen soll, mit welchem dieser Potentiale die ungewollte Verbindung besteht.

Im Stand der Technik wird ein solcher Fehler dadurch diagnostiziert, dass er ein Clipping (Übersteuerung) des entsprechenden AD-Wandlers auslöst. Eine solche Diagnose reicht jedoch nicht aus, weil ein AD-Wandler-Clipping auch andere Ursachen haben kann.

Offenbarung der Erfindung

Das Verfahren zum Erkennen eines Kurzschlusses nach Masse oder zur Betriebsspannung der Signalleitung eines Resolvers umfasst das Messen des Potentials der Signalleitungen der Empfängerspule gegenüber Masse an zwei symmetrisch zur Mitte der Erregerperiode gelegenen Abtastzeitpunkten (R und F). Mit diesen Daten erfolgt das Berechnen eines Offsetwerts $U_{DC}$ für das jeweilige Signalleitungspaar durch Bilden des Mittelwerts der vier Messwerte ($U_{HR}$, $U_{LR}$, $U_{HF}$ und $U_{LF}$) der jeweiligen Empfängerspule

$$U_{DC} = 1/4 * (U_{HR} + U_{LR} + U_{HF} + U_{LF}) \, ,$$

wobei H (High) und L (Low) die beiden Leitungen des Signalleitungspaars bezeichnen.

Das Identifizieren eines Kurzschluss und des Potentials (Richtung Masse oder $U_B$), auf das die kurzschlussbehaftete Leitung gezogen wird, wird dann dadurch ermöglicht, dass der Offsetwert mit Grenzwerten verglichen wird.

Ein anderer Aspekt der Erfindung besteht in einer Schaltung, die dieses Verfahren realisiert. Die Schaltung geht aus von der zu untersuchenden Schaltung, die eine Steuervorrichtung mit einem Prozessor, Leistungsstufen und erste Anschlüssen zum Bereitstellen der Signale für die Erregerleitungen umfasst, sowie zwei AD-Wandler, die an zweite Anschlüsse der Steuereinrichtung für die Signalleitungen angeschlossen sind und deren Ausgänge von der Software des Prozessors permanent gelesen und ausgewertet werden. Weiterhin gehören zu der Schaltung Erregerleitungen zu der Erregerspule des Resolvers und die die zu diagnostizierenden Signalleitungen für das Sinus- und Kosinussignal, die zurück zur Steuervorrichtung verlaufen. Für die Schaltung sind Pull-up-Widerstände erforderlich, die mit ihrem einen Ende mit einem der Anschlüsse für die Leitungen Sinusspule und der Kosinusspule verbunden sind und mit ihrem anderen Ende mit einem ersten Gleichspannungspotential $U_H$, sowie Pull-down-Widerstände, die mit ihrem einen Ende mit dem jeweils anderen der Anschlüsse für die Leitungen Sinusspule und der Kosinusspule verbunden sind und die mit ihrem anderen Ende mit einem zweiten Gleichspannungspotential $U_L$. Zum Messen des Potentials der Signalleitungen der Empfängerspule gegenüber Masse zu den Abtastzeitpunkten können entweder die Wandler für die Signaldaten genutzt werden, indem vier elektronische Schalter in die vier Verbindungen der Anschlüsse für die Signalleitungen zu den Eingängen dieser AD-Wandler eingefügt sind, wobei die Schalter so eingerichtet sind, dass sie jeweils einen Eingang des AD-Wandlers von der Signalleitung abtrennen und diesen Eingang zu den Abtastzeitpunkten temporär mit Masse verbinden. Alternativ können vier weitere AD-Wandler vorgesehen werden, bei denen ein Eingang auf Masse gelegt ist, und der andere Eingang mit jeweils einem der Anschlüsse für die Signalleitungen der Sinusspule und der Kosinusspule verbunden sind und die nur zu den Abtastzeitpunkten abgefragt werden. Außerdem umfasst die Schaltung eine Anzeige- und/oder Speichereinrichtung zum Anzeigen und/oder Speicher der vom Prozessor identifizierten Informationen, in die das positive Erkennen eines Kurzschlusses einer der Signalleitungen des Resolvers und das Bezeichnen der kurzschlussbehafteten Leitung und des Potentials, auf das diese Leitung gezogen wird, einbezogen ist.

Vorteile der Erfindung

Der Vorteil der Erfindung besteht darin, dass der zu diagnostizierende Fehler exakt von anderen Fehlern unterschieden werden kann (PinPointing-Diagnose).

Die Diagnose ist sehr schnell, denn bereits nach wenigen Perioden des Erregersignals mit einer typischen Dauer von 0,1 ms liegt eine zuverlässige Fehlerdiagnose vor, und es können ggf. geeignete Maßnahmen ergriffen werden. Damit werden insbesondere Anforderungen an Sensoren im Automobilbereich im Hinblick auf funktionelle Sicherheit wie auch im Hinblick auf OBD-Funktionalität (OBD = On Board Diagnose) erfüllt.

Vorteilhaft ist weiterhin, dass das erfindungsgemäße Verfahren mit geringer Ergänzung der üblichen Hardware einer Resolveransteuerung realisiert werden kann.

Kurze Beschreibung der Zeichnungen

Fig. 1 zeigt eine Schaltung gemäß einem Ausführungsbeispiel der Erfindung;

Fig. 2 erläutert schematisch die Schritte zum Ausführen des Verfahrens gemäß einem Ausführungsbeispiel der Erfindung; und

Fig. 3 erläutert die zeitliche Entwicklung des Potentials der Signalleitungen.

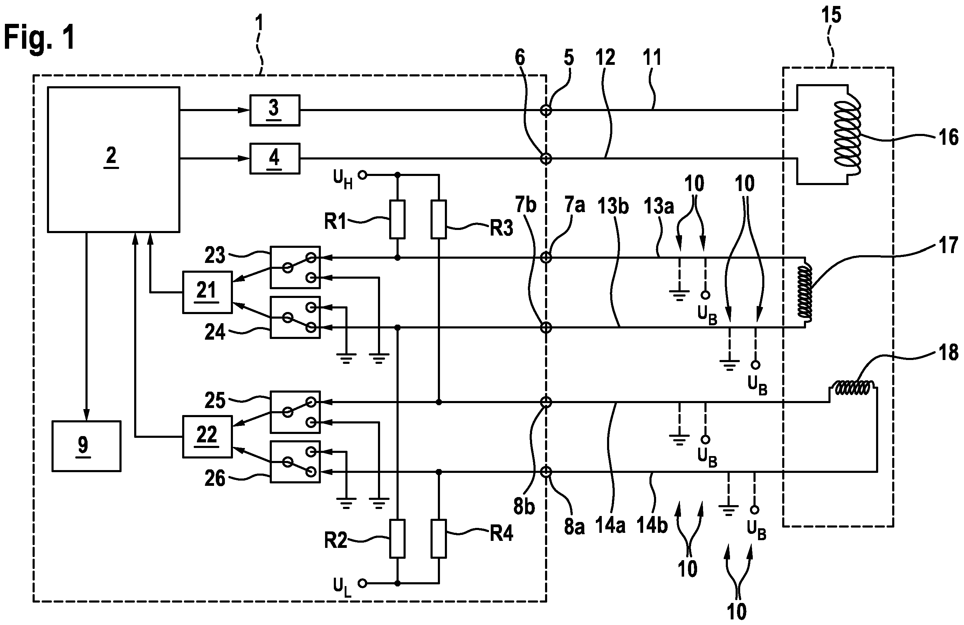

In Figur 1 steht die Steuervorrichtung 1 für den Resolver 15 im Zentrum, die in die Steuereinrichtung für ein Fahrzeug integriert sein kann (hier nicht dargestellt). Sie weist einen Prozessor 2 auf (oder nutzt diesen mit), der den korrekten Ablauf aller zu steuernden Resolverfunktionen überwacht und auch ggf. Fehlfunktionen anzeigt.

Die Steuervorrichtung 1 steuert insbesondere die Leistungsstufen 3 und 4 zum Bereitstellen des sinusförmigen Erregersignals für die Erregerspule 16 des Resolvers 15 an den ersten Anschlüssen 5 und 6. An den zweiten Anschlüssen 7a, 7b und 8a, 8b gelangen die Signale der Sinusspule 17 und der Kosinusspule 18, die die momentane Winkelstellung des Messobjekts (z.B. der Welle des Motors) repräsentieren, zur Steuervorrichtung 1 und können nach Wandlung in den AD-Wandlern 21 und 22 als digitales Signal softwaremäßig weiter bearbeitet werden.

Die Resolver-Signalleitungen 13a, 13b, 14a und 14b sind die Verbindung von den zweiten Anschlüssen 7a, 7b und 8a, 8b der Steuervorrichtung 1 zum Resolver 15, nämlich zu dessen Sinussule 17 und Kosinusspule 18. Diese Leitungen gilt es im Hinblick auf einen Kurzschluss 10, d.h. einer unerwünschten Verbindung nach Masse oder zur Betriebsspannung $U_B$ zu überwachen, was in Figur 1 mit den potentiellen, punktiert dargestellten Verbindungen 10 angedeutet ist.

Für die Kurzschlussdiagnose wird der Spannungsverlauf der einzelnen Signalleitungen gegen Masse ausgewertet, wobei die Auswertung für die Sinus- und die Kosinusspule 17 und 18 in gleicher Weise erfolgen. Dafür müssen die Signalleitungen bereits ohne Auftreten eines Kurzschlusses ein definiertes Potential haben. Hierfür dienen Pull-up-Widerstände $R_1$ und $R_3$, die mit ihrem einen Ende mit einem der Anschlüsse 7a, 8a für die Leitungen 13a, 14a Sinusspule 17 und der Kosinusspule 18 verbunden sind und mit ihrem anderen Ende mit einem erstes Gleichspannungspotential $U_H$; sowie Pull-down-Widerstände $R_2$ und $R_4$, die mit ihrem einen Ende mit dem anderen der Anschlüsse 7b, 8b für die Leitungen 13b, 14b der Sinusspule 17 und der Kosinusspule 18 verbunden sind und die mit ihrem anderen Ende mit einem zweiten Gleichspannungspotential $U_L$. Es ergibt sich entsprechend dem Widerstandsverhältnis eine Spannungsteilung zwischen $U_H$ und $U_L$, sofern der ohmsche Widerstand der Empfängerspulen klein ist gegen die Widerstände $R_1$, $R_2$, $R_3$ und $R_4$.

Um die Spannungen gegen Masse an den Signalleitungsanschlüssen mit den AD-Wandlern 21 und 22 für das Resolversignal zwecks Fehlerdiagnose zu messen, kann in die Verbindungen der Anschlüsse 7a, 7b, 8a und 8b für die Signalleitungen 13a, 13b, 14a und 14b zu Eingängen H und L der AD-Wandler 21, 22 jeweils ein elektronischer Schalter 23, 24, 25 und 26 eingefügt werden. Dabei sind diese vier Schalter so eingerichtet, dass sie jeweils einen Eingang des AD-Wandlers (21,22) von dem Anschluss 7a, 7b, 8a und 8b für die Signalleitungen 13a, 13b, 14a und 14b abtrennen und diesen Eingang temporär mit Masse verbinden. Alternativ dazu können statt der Schalter vier zusätzliche AD-Wandler eingesetzt werden (nicht in Fig. 1 dargestellt), die mit einem ihrer beiden Eingänge auf Masse gelegt ist, während der andere Eingang mit einem der Anschlüsse 7a, 7b, 8a und 8b für die Signalleitungen 13a, 13b, 14a und 14b verbunden ist.

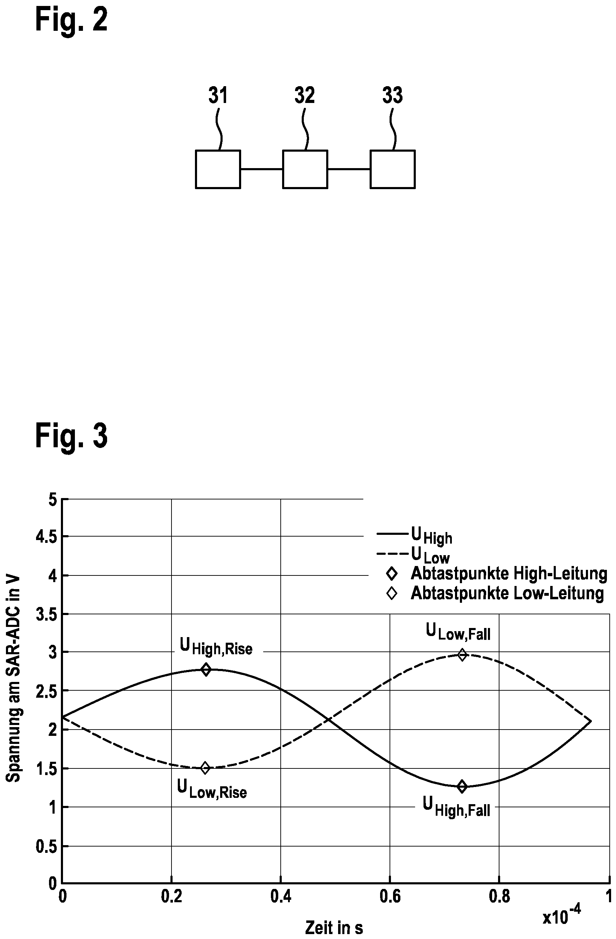

Das Messen (31 in Figur 2) des Potentials, d.h. der Spannung gegen Masse, an den Anschlüssen 7a, 7b, 8a und 8b der Signalleitungen 13a, 13b, 14a und 14b der Empfängerspulen 17 und 18 erfolgt, indem entweder für diese Abtastung der jeweilige Schalter 26, 27, 28 oder 29 umgelegt wird oder aber, bei Einsatz der alternativen Schaltung der jeweils entsprechende zusätzliche AD-Wandler abgefragt wird. Wie Figur 3 verdeutlicht, erfolgt die Messung an zwei symmetrisch zur Mitte der Erregerperiode gelegenen Abtastzeitpunkten R (oder Rise) und F (oder Fall), wobei die eine der Leitungen mit H (oder High) und die andere mit L (oder Low) bezeichnet wird.

Mit den sich so ergebenden vier Messwerten für jedes Leitungspaar 13a und 13b (bzw. 14a und 14b), also mit je zwei Messwerten an den beiden Leitungen H und L zu den jeweiligen Anschlüssen 7a und 7b (bzw. 8a und 8b) der zu messenden Empfängerspule 17 (bzw. 18) und zu den beiden Zeitpunkten R und F, erfolgt das Berechnen (32 in Figur 2) eines Offsetwerts $U_{DC}$. Dies geschieht durch Bilden des Mittelwerts dieser vier Messwerte $U_{HR}$, $U_{LR}$, $U_{HF}$ und $U_{LF}$:

$$U_{DC} = 1/4 * (U_{HR} + U_{LR} + U_{HF} + U_{LF})$$

Die Bedeutung dieses Offsetwerts erläutert Figur 3. Man erkennt, dass durch die zeitsymmetrische Abtastung sich die Potentialbeiträge, die von dem sinusförmigen Erregersignal induziert sind, einander gegenseitig aufheben, und als Mittelwert verbleibt die durch die Pull-up und Pull-down-Widerstände bestimmte Spannungsteilung. Im Fehlerfall jedoch ist der Offsetwert das durch den Kurzschluss hervorgerufene Potential, also Richtung Masse oder $U_B$, und die Widerstände $R_1$, $R_2$, $R_3$ und $R_4$ haben einen geringen oder keinen Einfluss mehr.

Somit kann das Identifizieren eines Kurzschluss 10 und des Potentials (Richtung Masse oder $U_B$), auf das die kurzschlussbehaftete Leitung gezogen wird (vgl. Figur 1), erfolgen, indem der Offsetwert $U_{DC}$ mit Grenzwerten $C_G$ für Masseschluss und $C_B$ für eine Verbindung zur Betriebsspannung $U_B$ verglichen wird (33 in Figur 2). Wird nämlich

$$U_{DC} < C_G$$

so kann ein Masseschluss diagnostiziert werden, während mit

$$U_{DC} > C_B$$

eine Verbindung mit der Betriebsspannung $U_B$ diagnostiziert werden kann.

Auf der Basis der Feststellung, welcher dieser Fälle vorliegt, kann der Prozessor 2 diagnostizieren, ob ein Kurzschluss 10 einer Signalleitung vorliegt, und es können die erforderlichen Maßnahmen erfolgen.

Eine Anzeige- und/oder Speichereinrichtung 9 dient zum Anzeigen und/oder Speichern der vom Prozessor 2 ermittelten Informationen. Das positive Erkennen eines Kurzschlusses 10, das Bezeichnen des kurzschlussbehafteten Leitungspaars und des Potentials (Masse oder $U_B$), auf das diese Leitung gezogen wird, sind in diese Anzeige einbezogen. Dabei kann das kurzschlussbehaftete Leitungspaar z.B. mit seiner Farbe oder Bezugsnummer bezeichnet werden.

**Patentansprüche**

1. Verfahren zum Erkennen eines Kurzschlusses (10) nach Masse oder zur Betriebsspannung ($U_B$) einer Signalleitung (11, 12) eines Resolvers (16) mit folgenden Schritten:

   Messen (31) des Potentials der Signalleitungen (13a, 13b; 14a, 14b) der Empfängerspule gegenüber Masse an zwei symmetrisch zur Mitte der Erregerperiode gelegenen Abtastzeitpunkten (R, F);
   Berechnen (32) eines Offsetwerts ($U_{DC}$) für das jeweilige Signalleitungspaar (13a, 13b; 14a, 14b) durch Bilden des Mittelwerts der vier Messwerte ($U_{HR}$, $U_{LR}$, $U_{HF}$, $U_{LF}$) der jeweiligen Empfängerspule (17, 18); und
   Identifizieren (33) eines Kurzschluss und des Potentials , auf das die kurzschlussbehaftete Leitung ziehbar ist, durch Vergleichen des Offsetwerts mit Grenzwerten.

**2.** Verfahren nach Anspruch 1, wobei Pull-up-Widerstände ($R_1$; $R_3$) und Pull-down-Widerstände ($R_2$; $R_4$), die an die Signalleitungen (13a, 13b; 14a, 14b) angeschlossen sind, mit ihrem anderen Ende mit einem Spannungspotential beaufschlagt werden.

**3.** Verfahren nach Anspruch 2, wobei sich die Spannungspotentiale der Pull-up-Widerstände ($R_1$; $R_3$) und der Pull-down-Widerstände ($R_2$; $R_4$), um einen konstanten Betrag voneinander unterscheiden, der kleiner ist als der Messbereich der AD-Wandler für die Messwerte der Empfängerspule.

**4.** Schaltung zum Erkennen eines Kurzschlusses einer Signalleitung (11, 12) eines Resolvers (16) nach Masse oder zur Betriebsspannung ($U_B$), aufweisend:

eine Steuervorrichtung (1) mit einem Prozessor (2), Leistungsstufen (3, 4) und ersten Anschlüssen (6, 7) zum Bereitstellen von Signalen für die Erregerleitungen (11, 12) zur Erregerspule (16) des Resolvers (15) und zweiten Anschlüssen (7a, 7b, 8a, 8b) zum Anschließen der Signalleitungen (13a, 13b, 14a, 14b) für die Signale der Sinus- und der Kosinusspule (17, 18); zwei AD-Wandler (21, 22), die an die zweiten Anschlüsse (7a, 7b und 8a, 8b) der Steuereinrichtung (1) angeschlossen sind und deren Ausgänge von der Software des Prozessors (2) lesbar und auswertbar sind; die Erregerleitungen (11, 12), die die ersten Anschlüssen (5, 6) der Erregerspule (16) mit dem Resolver (15) koppeln; die zu diagnostizierenden Signalleitungen (13a, 13b, 14a, 14b) für die vom Resolver (15) bereitgestellten Sinus- und Kosinussignale, die den Resolver mit den zweiten Anschlüssen (7a, 7b, 8a, 8b) der Steuervorrichtung (1) koppeln; Pull-up-Widerstände ($R_1$, $R_3$), die mit ihrem einen Ende mit einem der Anschlüsse (7a, 8a) für die Leitungen (13a, 14a) Sinusspule (17) und der Kosinusspule (18) und mit ihrem anderen Ende mit einem ersten Gleichspannungspotential ($U_H$) verbunden sind; Pull-down-Widerstände ($R_2$ und $R_4$), die mit ihrem einen Ende mit dem anderen der Anschlüsse (7b, 8b) für die Leitungen (13b, 14b) Sinusspule (17) und der Kosinusspule (18) und die mit ihrem anderen Ende mit einem zweiten Gleichspannungspotential ($U_L$) verbunden sind; entweder:

- vier elektronische Schalter (26, 27, 28, 29), die in die Verbindung der Anschlüsse (7a, 7b; 8a, 8b) für die Signalleitungen (13a, 13b; 14a, 14b) zu Eingängen (H, L) der AD-Wandler (21, 22) eingefügt sind, wobei die Schalter (26, 27, 28, 29) so ausgebildet und eingerichtet sind, dass sie jeweils einen Eingang des AD-Wandlers (21, 22) von der Signalleitung (13a, 13b; 14a, 14b) abtrennen und diesen Eingang temporär mit Masse verbinden;

oder:

- vier weitere AD-Wandler, bei denen ein Eingang auf Masse gelegt ist, und der andere Eingang mit jeweils einem der Anschlüsse (7a, 7b, 8a, 8b) für die Signalleitungen (13a, 13b, 14a, 14b) der Sinusspule (17) und der Kosinusspule (18) verbunden sind;

und
eine Anzeige- und/oder Speichereinrichtung (9) zum Anzeigen und/oder Speichern der vom Prozessor (2) identifizierten Informationen, in die das positive Erkennen eines Kurzschlusses (10) einer Signalleitung (11, 12) eines Resolvers (16) nach Masse oder zur Betriebsspannung ($U_B$) durch den Prozessor (2) einbezogen ist, wobei der Steuereinrichtung (1) dazu ausgestaltet ist, die Verfahrensschritte nach Anspruch 1 durchzuführen.

**5.** Schaltung nach Anspruch 4, wobei die Pull-up-Widerstände ($R_1$ und $R_3$) und Pull-down-Widerstände ($R_2$ und $R_4$) in die Steuervorrichtung (1) integriert sind.

**6.** Schaltung nach Anspruch 4 oder 5, wobei die Widerstandswerte der Pull-up-Widerstände ($R_1$ und $R_3$) und Pull-down-Widerstände ($R_2$ und $R_4$) groß sind gegen den ohmschen Widerstand der Sinusspule (17) und der Kosinusspule (18).

**Claims**

**1.** Method for detecting a short circuit (10) to ground or to the operating voltage ($U_B$) of a signal line (11, 12) of a resolver (16), having the following steps:

measuring (31) the potential of the signal lines (13a, 13b; 14a, 14b) of the receiver coil with respect to ground at two sampling instants (R, F) which are situated symmetrically with respect to the midpoint of the excitation period; calculating (32) an offset value ($U_{DC}$) for the respective signal line pair (13a, 13b; 14a, 14b) by forming the average of the four measured values

($U_{HR}$, $U_{LR}$, $U_{HF}$, $U_{LF}$) of the respective receiver coil (17, 18); and
identifying (33) a short circuit and the potential toward which the short-circuited line is able to be pulled, by comparing the offset value to limit values.

2. Method according to Claim 1, wherein pull-up resistors ($R_1$; $R_3$) and pull-down resistors ($R_2$; $R_4$) which are connected to the signal lines (13a, 13b; 14a, 14b) are supplied with a voltage potential via their other end.

3. Method according to Claim 2, wherein the voltage potentials of the pull-up resistors ($R_1$; $R_3$) and the pull-down resistors ($R_2$; $R_4$) differ from one another by a constant amount which is smaller than the measurement range of the A/D converters for the measured values of the receiver coil.

4. Circuit for detecting a short circuit of a signal line (11, 12) of a resolver (16) to ground or to the operating voltage ($U_B$), including:

a control device (1) including a processor (2), power stages (3, 4) and first terminals (6, 7) for providing signals for the excitation lines (11, 12) to the excitation coil (16) of the resolver (15), and second terminals (7a, 7b, 8a, 8b) for connecting the signal lines (13a, 13b, 14a, 14b) for the signals of the sine coil and the cosine coil (17, 18);
two A/D converters (21, 22) which are connected to the second terminals (7a, 7b and 8a, 8b) of the control device (1), the outputs of which being readable and evaluable by the software of the processor (2);
the excitation lines (11, 12) which couple the first terminals (5, 6) of the excitation coil (16) to the resolver (15);
the signal lines (13a, 13b, 14a, 14b) which are to be diagnosed for the sine and cosine signals provided by the resolver (15), and which couple the resolver to the two terminals (7a, 7b, 8a, 8b) of the control device (1);
pull-up resistors ($R_1$, $R_3$) which are connected via their one end to one of the terminals (7a, 8a) for the conductors (13a, 14a) of the sine coil (17) and of the cosine coil (18), and via their other end to a first DC voltage potential ($U_H$);
pull-down resistors ($R_2$ and $R_4$) which are connected via their one end to the other one of the terminals (7b, 8b) for the lines (13b, 14b) of the sine coil (17) and of the cosine coil (18), and which are connected via their other end to a second DC voltage potential ($U_L$);
either:

- four electronic switches (26, 27, 28, 29) which are inserted into the connection of the terminals (7a, 7b; 8a, 8b) for the signal lines (13a, 13b; 14a, 14b) to inputs (H, L) of the A/D converters (21, 22), wherein the switches (26, 27, 28, 29) are designed and configured in such a way that they respectively disconnect one input of the A/D converter (21, 22) from the signal line (13a, 13b; 14a, 14b) and temporarily connect this input to ground;

or:

- four additional A/D converters in which one input is set to ground, and the other input is connected to one of the terminals (7a, 7b, 8a, 8b) for the signal lines (13a, 13b, 14a, 14b) of the sine coil (17) and the cosine coil (18);

and
a display and/or storage device (9) for displaying and/or storing the information identified by the processor (2), into which the positive detection of a short circuit (10) of a signal line (11, 12) of a resolver (16) to ground or to the operating voltage ($U_B$) by the processor (2) is incorporated, wherein the control device (1) is designed to carry out the method steps according to Claim 1.

5. Circuit according to Claim 4, wherein the pull-up resistors ($R_1$ and $R_3$) and pull-down resistors ($R_2$ and $R_4$) are integrated into the control device (1).

6. Circuit according to Claim 4 or 5, wherein the resistance values of the pull-up resistors ($R_1$ and $R_3$) and pull-down resistors ($R_2$ and $R_4$) are large relative to the ohmic resistance of the sine coil (17) and the cosine coil (18) .

**Revendications**

1. Procédé de détection d'un court-circuit (10) vers la masse ou vers la tension de service ($U_B$) d'une ligne de signal (11, 12) d'un résolveur (16), comprenant les étapes suivantes consistant à :

mesurer (31) le potentiel des lignes de signaux (13a, 13b ; 14a, 14b) de la bobine réceptrice par rapport à la masse à deux instants de prélèvement (R, F) situés symétriquement par rapport au milieu de la période d'excitation ;
calculer (32) une valeur de décalage ($U_{DC}$) pour la paire respective de lignes de signaux (13a, 13b ; 14a, 14b) en calculant la moyenne des quatre valeurs mesurées ($U_{HR}$, $U_{LR}$, $U_{HF}$, $U_{LF}$)

de la bobine réceptrice respective (17, 18) ; et identifier (33) un court-circuit et le potentiel auquel est soumise la ligne affectée par le court-circuit en comparant la valeur de décalage à des valeurs limites.

2. Procédé selon la revendication 1, dans lequel des résistances de rappel au niveau haut ($R_1$ ; $R_3$) et des résistances de rappel au niveau bas ($R_2$ ; $R_4$) reliées aux lignes de signaux (13a, 13b ; 14a, 14b) sont alimentées à leur autre extrémité avec un potentiel de tension.

3. Procédé selon la revendication 2, dans lequel les potentiels de tension des résistances de rappel au niveau haut ($R_1$ ; $R_3$) et des résistances de rappel au niveau bas ($R_2$ ; $R_4$) diffèrent l'un de l'autre d'une quantité constante qui est inférieure à la plage de mesure des convertisseurs AD pour les valeurs de mesure de la bobine réceptrice.

4. Circuit de détection d'un court-circuit d'une ligne de signal (11, 12) d'un résolveur (16) vers la masse ou la tension de service ($U_B$), comportant :

un dispositif de commande (1) comportant un processeur (2), des étages de puissance (3, 4) et des premières bornes (6, 7) permettant de fournir des signaux destinés aux lignes d'excitation (11, 12) à la bobine d'excitation (16) du résolveur (15) et des secondes bornes (7a, 7b, 8a, 8b) permettant de connecter les lignes de signaux (13a, 13b, 14a, 14b) destinées aux signaux des bobines sinus et cosinus (17, 18) ;
deux convertisseurs AD (21, 22) qui sont connectés aux secondes bornes (7a, 7b et 8a, 8b) du dispositif de commande (1) et dont les sorties peuvent être lues et évaluées par le logiciel du processeur (2) ;
les lignes d'excitation (11, 12) qui couplent les premières bornes (5, 6) de la bobine d'excitation (16) au résolveur (15) ;
les lignes de signaux (13a, 13b, 14a, 14b) à diagnostiquer et destinées aux signaux sinus et cosinus fournis par le résolveur (15), qui couplent le résolveur aux secondes bornes (7a, 7b, 8a, 8b) du dispositif de commande (1) ;
des résistances de rappel au niveau haut ($R_1$, $R_3$) qui sont connectées par leur première extrémité à l'une des bornes (7a, 8a) destinées aux lignes (13a, 14a) de la bobine sinus (17) et de la bobine cosinus (18) et par leur autre extrémité à un premier potentiel de tension continue ($U_H$) ;
des résistances de rappel au niveau bas ($R_2$ et $R_4$) qui sont connectées par une extrémité à l'autre des bornes (7b, 8b) destinées aux lignes (13b, 14b) de la bobine sinus (17) et de la bobine cosinus (18) et qui sont connectées par leur autre extrémité à un second potentiel de tension continue ($U_L$) ;
et soit :

- quatre commutateurs électroniques (26, 27, 28, 29) qui sont insérés dans la connexion des bornes (7a, 7b ; 8a, 8b) destinées aux lignes de signaux (13a, 13b ; 14a, 14b) aux entrées (H, L) des convertisseurs AD (21, 22), dans lequel les commutateurs (26, 27, 28, 29) sont réalisés et conçus pour déconnecter chaque entrée du convertisseur AD (21, 22) de la ligne de signal (13a, 13b ; 14a, 14b) et pour connecter temporairement ladite entrée à la masse ;

soit :

- quatre autres convertisseurs AD dont une entrée est reliée à la masse et dont l'autre entrée est reliée à l'une des bornes (7a, 7b, 8a, 8b) destinées aux lignes de signaux (13a, 13b, 14a, 14b) de la bobine sinus (17) et de la bobine cosinus (18), respectivement ;

et
un dispositif d'affichage et/ou de mémoire (9) destiné à afficher et/ou stocker les informations identifiées par le processeur (2), dans lequel la détection positive d'un court-circuit (10) d'une ligne de signal (11, 12) d'un résolveur (16) vers la masse ou vers la tension de service ($U_B$) est prise en compte par le processeur (2),
dans lequel le dispositif de commande (1) est conçu pour mettre en oeuvre les étapes de procédé selon la revendication 1.

5. Circuit selon la revendication 4, dans lequel les résistances de rappel au niveau haut ($R_1$ et $R_3$) et les résistances de rappel au niveau bas ($R_2$ et $R_4$) sont intégrées dans le dispositif de commande (1).

6. Circuit selon la revendication 4 ou 5, dans lequel les valeurs de résistance des résistances de rappel au niveau haut ($R_1$ et $R_3$) et des résistances de rappel au niveau bas ($R_2$ et $R_4$) sont élevées par rapport à la résistance ohmique de la bobine sinus (17) et de la bobine cosinus (18).

Fig. 1

# Fig. 2

# Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011078583 A1

- EP 2562516 A